# EUROPEAN PATENT APPLICATION

(11) **EP 4 002 430 A1**
(43) Date of publication of application: **25.05.2022**
(21) Application number: 21207718.4
(22) Date of filing: 11.11.2021
(51) Int. Cl.: H01L 21/18, H01L 21/02, H01L 21/30, H01L 21/322

(54) **BONDED WAFER AND METHOD OF PRODUCING BONDED WAFER**

(30) Priority: 11.11.2020 JP 2020187943
(71) Applicant: Sumco Corporation, Minato-ku, Tokyo 105-8634 (JP)
(72) Inventor: KOGA, Yoshihiro, Tokyo, 1058634 (JP)
(74) Representative: Sticht, Andreas

(57) **Abstract**

Provided is a bonded wafer and a method of producing a bonded wafer that can reduce device defects. The method of producing a bonded wafer includes: a step of preparing an active layer wafer; a step of producing a room temperature vacuum bonded wafer by bonding together the support substrate wafer and the active layer wafer by room temperature vacuum bonding such that an amorphous layer having a thickness of 1 nm to 10 nm is present in an interior of the wafer; and a step of performing heat treatment on the room temperature vacuum bonded wafer in an atmosphere consisting of at least one of hydrogen and nitrogen at a heat treatment temperature of 100 °C or more and 650 °C or less for a heat treatment time of 10 minutes or more and 1 hour or less. The bonded wafer includes an amorphous layer having a thickness of 1 nm to 10 nm in an interior of the wafer. One of nitrogen and hydrogen is present in the amorphous layer with a peak concentration of 1 × 10¹⁹ atoms/cm³ or more in the depth direction, measured by SIMS analysis.

## Description

### TECHNICAL FIELD

This disclosure relates to a bonded wafer and a method of producing a bonded wafer.

### BACKGROUND

Conventionally, bonded wafers having getting capability improved to reduce diffusion of heavy metals into a device formation region have been proposed as bonded wafers used in imaging devices, power devices, etc. (for example, JP 2018-064057 A (PTL 1)).

### CITATION LIST

### Patent Literature

PTL 1: JP 2018-064057 A

### SUMMARY

However, although the technique disclosed in PTL 1 can improve gettering performance, defects would be formed during the device process (hereinafter, such defects are referred to as process induced defects (PIDs)), and if PIDs remain after the assembly process, the device characteristics would be poor. Particularly, the performance of imaging devices and power devices is significantly susceptible to PIDs. For example, there have been concerns that, the dark current would increase in the case of imaging devices, and the standby leakage current would increase in the case of lateral power devices.

It could therefore be helpful to provide a bonded wafer and a method of producing a bonded wafer that can reduce device defects.

This disclosure primarily includes the following features.
(1) A method of producing a bonded wafer, comprising:
   a step of preparing a support substrate wafer;
   a step of preparing an active layer wafer;
   a step of producing a room temperature vacuum bonded wafer by bonding together the support substrate wafer and the active layer wafer by room temperature vacuum bonding such that an amorphous layer having a thickness of 1 nm to 10 nm is present in an interior of the wafer; and
   a step of performing heat treatment on the room temperature vacuum bonded wafer in an atmosphere consisting of at least one of hydrogen and nitrogen at a heat treatment temperature of 100 °C or more and 650 °C or less for a heat treatment time of 10 minutes or more and 1 hour or less.
(2) A bonded wafer comprising an amorphous layer having a thickness of 1 nm to 10 nm in an interior of the wafer,
   wherein one of nitrogen and hydrogen is present in the amorphous layer with a peak concentration of 1 × 10¹⁹ atoms/cm³ or more in the depth direction, measured by SIMS analysis.
(3) The bonded wafer according to (2) above, wherein the amorphous layer is located at a position at a depth of 1 µm or more from a surface of the bonded wafer on the active layer wafer side.
(4) The bonded wafer according to (2) or (3) above, wherein at least one of nitrogen and hydrogen is present at a position at a depth of 1 µm or more from a surface of the bonded wafer on the active layer wafer side.

This disclosure can provide a bonded wafer and a method of producing a bonded wafer that can reduce device defects.

### BRIEF DESCRIPTION OF THE DRAWINGS

In the accompanying drawings:
FIG. 1 is a flow diagram illustrating a method of producing a bonded wafer, according to one embodiment of this disclosure;
FIG. 2 is a cross-sectional view of a bonded wafer according to one embodiment of this disclosure;
FIG. 3 is a schematic view of a pn junction diode fabricated in Examples;
FIG. 4 is a diagram illustrating the SIMS profile results in Conventional Example 1-2;
FIG. 5 is a diagram illustrating the SIMS profile results in Invention Example 2-2; and
FIG. 6 is a diagram illustrating the SIMS profile results in Comparative Example 1-2.

### DETAILED DESCRIPTION

Embodiments of a method of producing a bonded wafer and a bonded wafer, according to this disclosure will now be described in detail with reference to the drawings.

### < Method of producing bonded wafer >

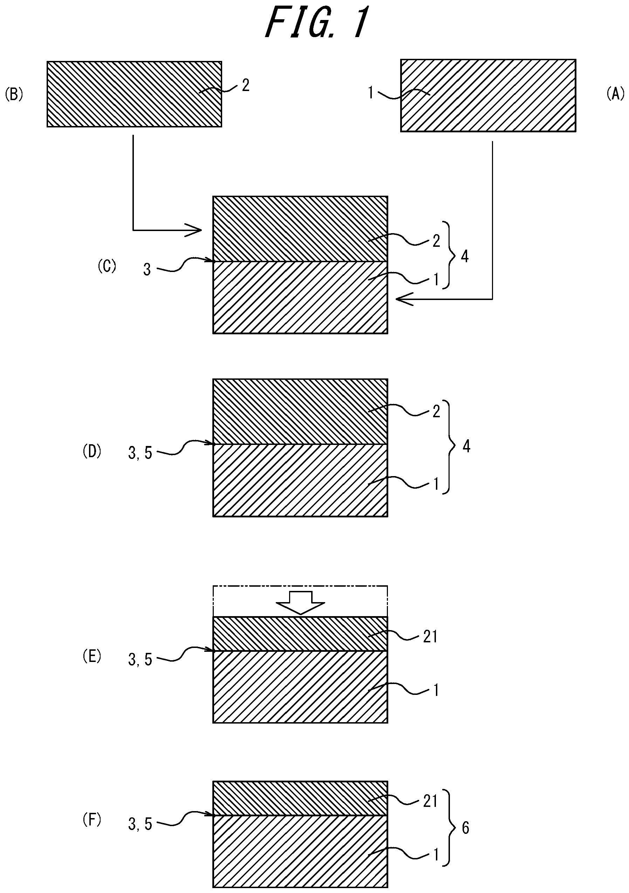

FIG. 1 is a flow diagram illustrating a method of producing a bonded wafer, according to one embodiment of this disclosure;

As illustrated in FIG. 1, in this embodiment, first, a support substrate wafer 1 is prepared (Step (A)). The support substrate wafer 1 may be, for example, a silicon wafer. As a silicon wafer, a wafer obtained by growing a single crystal silicon ingot or a polycrystalline silicon ingot by the Czochralski process (CZ process) or the floating zone melting process (FZ process) and slicing the ingot using a wire saw or the like can be used. The support substrate wafer 1 may be made to be n-type or p-type by adding a given impurity. The resistivity of the support substrate wafer may be set to, for example but not limited to, 10 Ω·cm to 1000 Ω·cm.

Further, in this embodiment, an active layer wafer 2 is prepared (Step (B)). The active layer wafer 2 may also be, for example, a silicon wafer. As with the above, as a silicon wafer, a wafer obtained by growing a single crystal silicon ingot or a polycrystalline silicon ingot by the Czochralski process (CZ process) or the floating zone melting process (FZ process) and slicing the ingot using a wire saw or the like can be used. The active layer wafer 2 may be made to be n-type or p-type by adding a given impurity. The resistivity of the active layer wafer may be set to, for example but not limited to, 1 Ω·cm to 10 Ω·cm.

Next, in this embodiment, the support substrate wafer 1 and the active layer wafer 2 are bonded by room temperature vacuum bonding to produce a room temperature vacuum bonded wafer 4 such that an amorphous layer 3 having a thickness of 1 nm to 10 nm is present in the interior of the wafer 4 (Step (C)).

The room temperature vacuum bonding is a method by which the support substrate wafer 1 and the active layer wafer 2 are bonded together under vacuum at room temperature without heating. In this embodiment, the bond surface of the support substrate wafer 1 and a bond surface of the active layer wafer 2 are subjected to activation by irradiating the surfaces with an ion beam of for example argon under vacuum at room temperature, so that both bond surfaces are activated. Thus, an amorphous layer is formed on the activated surfaces, and dangling bonds (bonding hands) that silicon inherently has appear. Accordingly, when the two activated surfaces are subsequently brought into contact under vacuum at room temperature, the bonding force acts instantly, thus the firmly bonded room temperature vacuum bonded wafer 4 can be produced.

Now, the thickness of the amorphous layer 3 can be made to be 1 nm to 10 nm, for example by controlling the acceleration voltage for the ion beam in the activation on the bond surfaces, and the acceleration voltage may be set to, for example but not limited to, 100 keV to 5 keV.

Here, the inventor of this disclosure diligently studied to address the above challenge, and found that performing a given heat treatment step on the room temperature vacuum bonded wafer allows for passivation of PIDs remaining in a room temperature vacuum bonded wafer, and in particular, performing the heat treatment in an atmosphere of at least one hydrogen and nitrogen at relatively low temperatures makes it possible to obtain a concentration peak of hydrogen or nitrogen that is no lower than a given value in an amorphous layer in the room temperature vacuum bonded wafer without destroying the amorphous layer, and thus hydrogen or nitrogen with which the PIDs can be passivated can be contained in the room temperature vacuum bonded wafer.

This being the case, next, in this embodiment, the room temperature vacuum bonded wafer 4 produced in Step (C) above is subjected to heat treatment in an atmosphere of at least one of hydrogen and nitrogen (hydrogen only, nitrogen only, or hydrogen and nitrogen) at a heat treatment temperature of 100 °C or more and 650 °C or less for a heat treatment time of 10 minutes or more and 1 hour or less (Step (D)). Thus, without destroying the amorphous layer 3, a region 5 in which nitrogen or hydrogen is present with a peak concentration of 1 × 10¹⁹ atoms/cm³ or more in the depth direction, measured by SIMS analysis, can be formed in the amorphous layer 3. Specifically, a heat treatment temperature of more than 650 °C destroys the amorphous layer, whereas a heat treatment temperature of less than 100 °C cannot allow hydrogen or nitrogen to be sufficiently incorporated into the amorphous layer even if the amorphous layer is present. Further, a heat treatment time of less than 10 minutes also cannot allow hydrogen or nitrogen to be sufficiently incorporated into the amorphous layer, whereas a heat treatment time of more than 1 hour destroys the amorphous layer.

In this embodiment, after that, the active layer wafer 2 of the room temperature vacuum bonded wafer 4 is subjected to grinding and polishing to form a device formation region (Step (E)). As in this embodiment, performing a grinding and polishing step after the heat treatment (Step (C)) can remove dopant species that can be diffused by the heat treatment (in the case of in a hydrogen atmosphere) and a nitride film (in the case of in a nitrogen atmosphere).

In this manner, a bonded wafer 6 having a thinned active layer wafer 21 as the device formation region is completed (Step (F)).

The operation and effect of the method of producing a bonded wafer, according to this embodiment will now be described.

According to a method of producing a bonded wafer, according to this embodiment, the region 5 in which nitrogen or hydrogen is present with a peak concentration of 1 × 10¹⁹ atoms/cm³ or more in the depth direction by secondary ion mass spectrometry (SIMS) can be formed in the amorphous layer 3 by the heat treatment in Step (D) above. This allows hydrogen or nitrogen with which PIDs are passivated to be sufficiently contained in the bonded wafer, thus the PIDs are passivated to be electrically deactivated, which can reduce device defects. Further, the gettering effect of the amorphous layer can be maintained.

Now, in terms of obtaining a higher concentration peak of hydrogen or nitrogen by making the amorphous layer to sufficiently remain, the heat treatment temperature in the heat treatment in Step (D) above is preferably 500 °C or less, more preferably 400 °C or less. Further, the heat treatment time in the heat treatment in Step (D) above is more preferably 20 minutes or more and 50 minutes or less. A heat treatment time of 50 minutes or allows the amorphous layer to remain even more, and a heat treatment time of 20 minutes or more allows hydrogen or nitrogen to be more sufficiently incorporated into the amorphous layer.

### (Variation)

In the above embodiment, the grinding and polishing step (Step (E)) is performed after the heat treatment step (Step (D)); alternatively, the grinding and polishing step (Step (E)) may be performed before the heat treatment step (Step (D)). When heat treatment is performed after thinning the active layer wafer 2, the distance from the surface of the thinned active layer wafer 21 to the amorphous layer 3 is reduced, thus the amount of hydrogen or nitrogen to be incorporated into the amorphous layer 3 can be increased, which improves the passivation effect and would further reduce device defects.

In the above variation, particularly when heat treatment is performed in a hydrogen atmosphere, another grinding and polishing step is preferably performed after the heat treatment step (Step (D)) performed after the grinding and polishing step (Step (E)). This is because a portion in which the dopant concentration is low due to the out diffusion caused by heat treatment can be ground and polished, and thus the quality of the device region can be increased.

Further, in the above variation, particularly when heat treatment is performed in nitrogen atmosphere, another grinding and polishing step is preferably performed after the heat treatment step (Step (D)) performed after the grinding and polishing step (Step (E)). This is because a nitride film which would be formed by the heat treatment can be removed.

### < Bonded wafer >

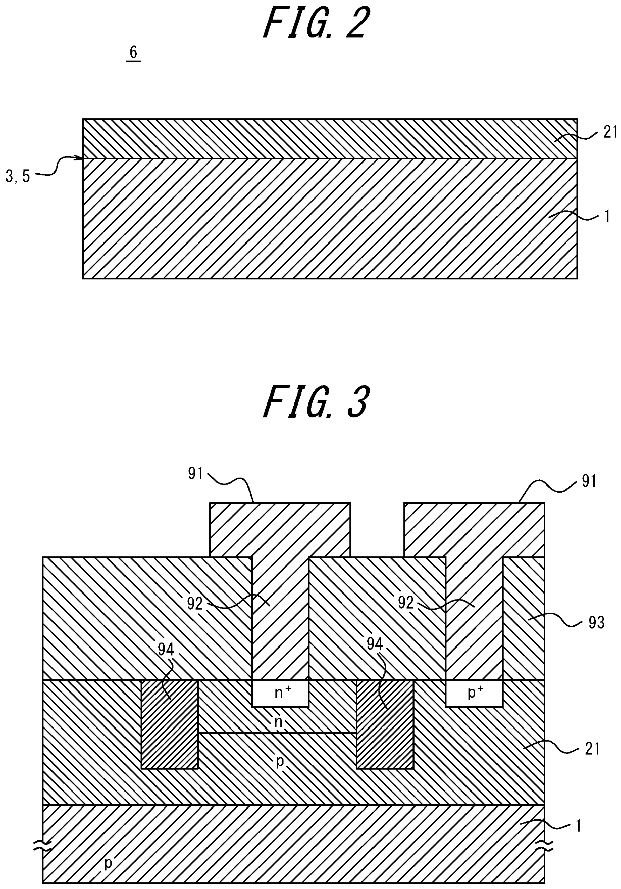

A bonded wafer according to one embodiment of this disclosure will now be described. FIG. 2 is a cross-sectional view of a bonded wafer according to one embodiment of this disclosure. As illustrated in FIG. 2, the bonded wafer 6 has the support substrate wafer 1 and the thinned active layer wafer 21 (thinned by the grinding and polishing step) bonded together. The thinned active layer wafer 21 serves as a device formation region. As described above, the support substrate wafer 1 may be, for example, a silicon wafer. The support substrate wafer 1 may be n-type or p-type. The resistivity of the support substrate wafer may be set to, for example but not limited to, 10 Ω·cm to 1000 Ω·cm.The active layer wafer 21 may also be, for example, a silicon wafer. The active layer wafer 21 may be n-type or p-type. The resistivity of the active layer wafer 21 may be set to, for example but not limited to, 1 Ω·cm to 10 Ω·cm.The thickness of the (thinned) active layer wafer 21 may be set to, for example but not limited to, 2 µm to 10 µm.

The bonded wafer 6 has the amorphous layer 3 having a thickness of 1 nm to 10 nm in the interior of the wafer, and has the region 5 in which nitrogen or hydrogen is present with a peak concentration of 1 × 10¹⁹ atoms/cm³ in the depth direction, measured by SIMS analysis, in the amorphous layer 3. The above peak concentration is preferably 2 × 10¹⁹ atoms/cm³ or more, more preferably 3 × 10¹⁹ atoms/cm³ or more.

The amorphous layer 3 is preferably present at a position at a depth of 1 µm or more (more preferably 2 µm or more) from the surface of the bonded wafer 6 on the active layer wafer 21 side. Forming the amorphous layer 3 under and close to the device formation region increases the getting capability on heavy metals exhibiting a low rate of diffusion (for example, Ti, Mo, W, etc.). Similarly, at least one of nitrogen and hydrogen is preferably present at a position at a depth of 1 µm or more (more preferably 2 µm or more) from the surface of the bonded wafer 6 on the active layer wafer 21 side. This increases the amount of hydrogen or nitrogen diffused into the device formation region (passivation level).

Embodiments of this disclosure have been described above; however, this disclosure is in no way limited to the above embodiments. For example, Step (A) and Step (B) may be performed in either order or may be performed in a concurrent manner.

Examples of this disclosure will now be described; however, this disclosure is not limited to the Examples in any way.

### EXAMPLES

### (Example 1)

With a view to studying the effect obtained by this disclosure, for each example, a p-type CZ silicon wafer having a resistivity of 10 Ω·cm and a thickness of 750 µm was prepared as a support substrate wafer, and a p-type FZ wafer having a resistivity of 1 Ω·cm was prepared as an active layer wafer. These wafers were bonded together by room temperature vacuum bonding to produce a room temperature vacuum bonded wafer having an amorphous layer with a thickness of 5 nm, and heat treatment was then performed in a 100 % hydrogen atmosphere at 100 °C (Invention Examples 1-1, 1-2), 400 °C (Invention Examples 2-1, 2-2), 650 °C (Invention Examples 3-1, 3-2), and 700 °C (Comparative Examples 1-1, 1-2) for 1 hour. In Conventional Examples, heat treatment was skipped and was not performed (Conventional Examples 1-1, 1-2). After heat treatment, the active layer wafer was ground and polished to a thickness of 5 µm.

In Invention Examples 1-1, 2-1, and 3-1; Comparative Example 1-1; and Conventional Example 1-1, a pn junction diode as depicted in FIG. 3 was fabricated in an active layer region, and a voltage was applied between metals (0 V to a p⁺ region, and -3V to 3V to n⁺ region) to evaluate the diode characteristics. Each pn junction diode was formed by first forming an n region doped with phosphorus by photolithography, performing heat treatment in a nitrogen atmosphere at 1000 °C for 2 hours, and then performing etching by photolithography, followed by the deposition of SiO₂ by CVD to form an STI region 94, then depositing an interlayer insulator 93, then performing etching by photolithography, and then adding phosphorus and boron, followed by heat treatment in a nitrogen atmosphere at 900 °C for 0.5 hour to form contact regions n⁺ and p⁺, and implanting metals 91 into through-hole vias 92. The evaluation results are given in Table 1. As given in Table 1, the reverse current (3V was applied to n⁺) was approximately 1 × 10⁻¹⁰ A/cm² in Invention Examples 1-1, 2-1, and 3-1; whereas the reverse current was 1 × 10⁻⁹ A/cm² in Comparative Example 1-1 and 1 × 10⁻⁸ A/cm² in Conventional Example 1-1. Reverse leakage current was found to have been reduced in Invention Examples.

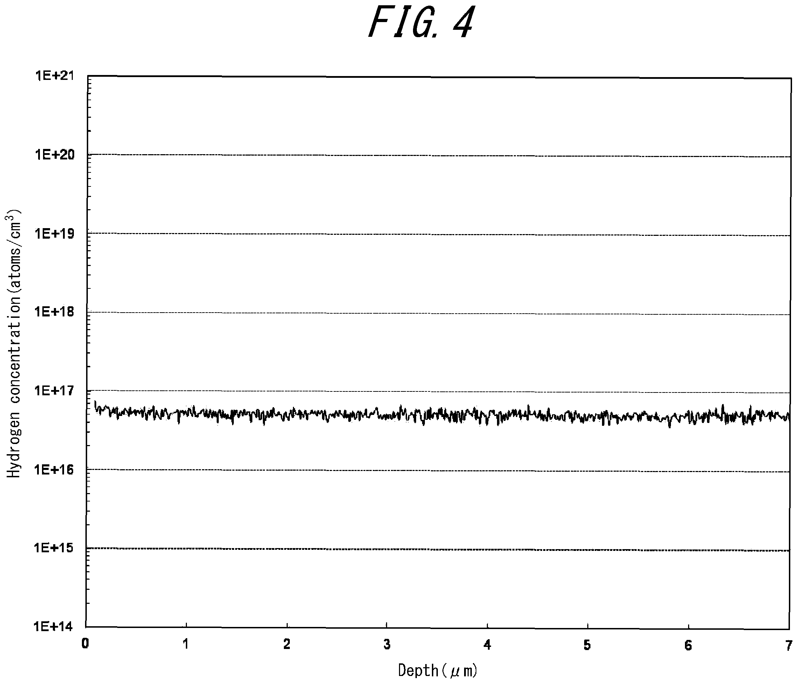

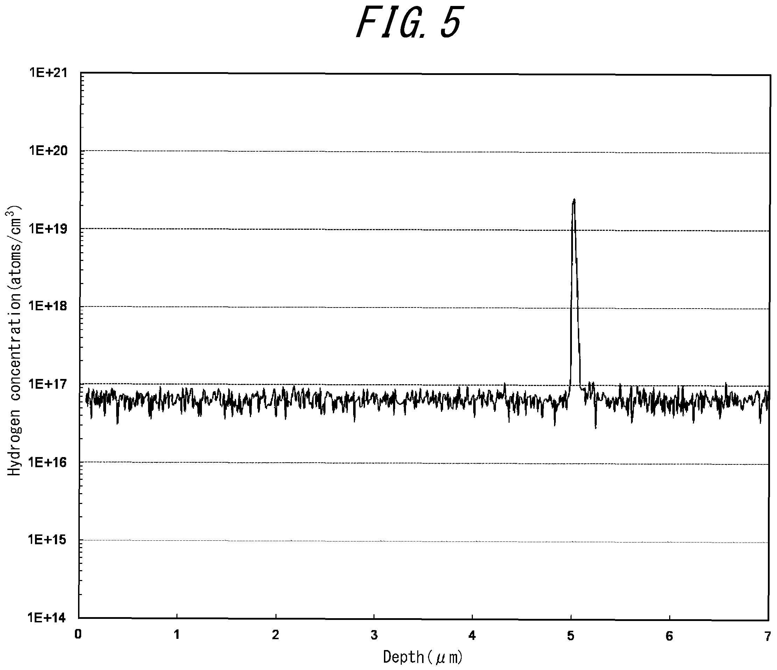

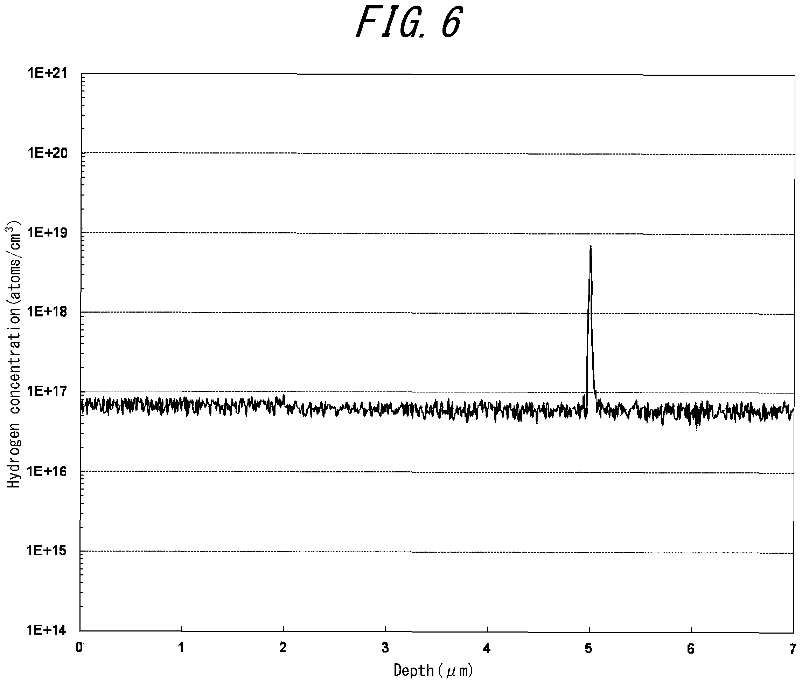

Next, for evaluation analysis, the hydrogen concentration profile on the wafer surface was evaluated using SIMS analysis for Invention Examples 1-2, 2-2, and 3-2; Comparative Example 1-2; and Conventional Example 1-2. As a result, in Invention Examples 1-2, 2-2, and 3-2, a hydrogen peak concentration of 1 to 4 × 10¹⁹ atoms/cm³ was found at a position at a depth of 5 µm from the surface, whereas a hydrogen peak concentration of 7.2 × 10¹⁸ atoms/cm³ was found at the same depth in Comparative Example 1-2, and the hydrogen concentration at the same depth was approximately the lower detection limit in Conventional Example 1-2. The evaluation results are given in Table 1 and FIGS. 4 to 6. FIG. 4 is a diagram illustrating the SIMS profile results in Conventional Example 1-2; FIG. 5 is a diagram illustrating the SIMS profile results in Invention Example 2-2; and FIG. 6 is a diagram illustrating the SIMS profile results in Comparative Example 1-2.

Further, as a result of cross-sectional TEM observation performed on Invention Examples 1-2, 2-2, 3-2; Comparative Example 1-2; and Conventional Example 1-2, an amorphous layer was found at a position at a depth of 5 µm from the surface in Invention Examples 1-2, 2-2, and 3-2; and Conventional Example 1-2, whereas no amorphous layer was found but dislocations were found at a position at a depth of 5 µm from the surface in Comparative Example 1-2. The evaluation results are given in Table 1.

**Table 1**

| | Conventional Example 1-1, 1-2 | Invention Example 1-1, 1-2 | Invention Example 2-1, 2-2 | Invention Example 3-1, 3-2 | Comparative Example 1-1, 1-2 |
|---|---|---|---|---|---|
| | No annealing | 100°C Hydrogen annealing | 400°C Hydrogen annealing | 650°C Hydrogen annealing | 700°C Hydrogen annealing |
| Reverse leakage current (A/cm⁻²) | 1.4 × 10⁻⁸ | 1.3 × 10⁻¹⁰ | 1.2 × 10⁻¹⁰ | 1.1 × 10⁻¹⁰ | 1.1 × 10⁻⁹ |
| Hydrogen peak concentration (atoms/cm⁻³) | 5.0 × 10¹⁶ (Lower detection limit) | 3.9 × 10¹⁹ | 2.5 × 10¹⁹ | 1.0 × 10¹⁹ | 7.2 × 10¹⁸ |
| Thickness of amorphous layer (nm) | 5.2 | 5.1 | 4.8 | 2.2 | 0 |

### (Example 2)

The hydrogen atmosphere in the heat treatment step in Example 1 was changed to a nitrogen atmosphere, and similar experiments were performed and similar evaluations were performed. The evaluation results are given in Table 2. As given in Table 2, reverse leakage current was found to have been reduced in Invention Examples also in the case of heat treatment in a nitrogen atmosphere.

**Table 2**

| | Conventional Example 2-1, 2-2 | Invention Example 4-1, 4-2 | Invention Example 5-1, 5-2 | Invention Example 6-1, 6-2 | Comparative Example 2-1, 2-2 |
|---|---|---|---|---|---|
| | No annealing | 100°C Nitrogen annealing | 400°C Nitrogen annealing | 650°C Nitrogen annealing | 700°C Nitrogen annealing |
| Reverse leakage current (A/cm⁻²) | 1.5 × 10⁻⁸ | 1.5 × 10⁻¹⁰ | 1.3 × 10⁻¹⁰ | 1.2 × 10⁻¹⁰ | 2.4 × 10⁻⁹ |
| Nitrogen peak concentration (atoms/cm⁻³) | 2.0 × 10¹⁶ (Lower detection limit) | 3.2 × 10¹⁹ | 2.7 × 10¹⁹ | 1.4 × 10¹⁹ | 6.6 × 10¹⁸ |
| Thickness of amorphous layer (nm) | 5.4 | 5.4 | 4.5 | 2.3 | 0 |

### (Example 3)

Experiments similar to those in Example 1 were performed in a hydrogen atmosphere with the argon ion irradiation conditions (acceleration voltage for the ion beam) in room temperature vacuum bonding being controlled and the thickness of the amorphous layer being set to 10 nm; and similar evaluations were performed. The evaluation results are given in Table 3. Reverse leakage current was found to have been reduced in Invention Examples also in the case where the thickness of the amorphous layer was 10 nm.

**Table 3**

| | Conventional Example 3-1, 3-2 | Invention Example 7-1, 7-2 | Invention Example 8-1, 8-2 | Invention Example 9-1, 9-2 | Comparative Example 3-1, 3-2 |
|---|---|---|---|---|---|
| | No annealing | 100°C Hydrogen annealing | 400°C Hydrogen annealing | 650°C Hydrogen annealing | 700°C Hydrogen annealing |
| Reverse leakage current (A/cm⁻²) | 9.8 × 10⁻⁹ | 9.1 × 10⁻¹¹ | 9.2 × 10⁻¹¹ | 9.3 × 10⁻¹¹ | 8.7 × 10**⁻¹⁰** |
| Hydrogen peak concentration (atoms/cm⁻³) | 5.0 × 10¹⁶ (Lower detection limit) | 7.9 × 10¹⁹ | 5.3 × 10¹⁹ | 2.1 × 10¹⁹ | 7.2 × 10¹⁸ |
| Thickness of amorphous layer (mn) | 9.8 | 9.9 | 9.7 | 4.5 | 0 |

## Claims

1. A method of producing a bonded wafer, comprising:
a step of preparing a support substrate wafer;
a step of preparing an active layer wafer;
a step of producing a room temperature vacuum bonded wafer by bonding together the support substrate wafer and the active layer wafer by room temperature vacuum bonding such that an amorphous layer having a thickness of 1 nm to 10 nm is present in an interior of the wafer; and
a step of performing heat treatment on the room temperature vacuum bonded wafer in an atmosphere consisting of at least one of hydrogen and nitrogen at a heat treatment temperature of 100 °C or more and 650 °C or less for a heat treatment time of 10 minutes or more and 1 hour or less.

2. A bonded wafer comprising an amorphous layer having a thickness of 1 nm to 10 nm in an interior of the wafer,
wherein one of nitrogen and hydrogen is present in the amorphous layer with a peak concentration of 1 × 10¹⁹ atoms/cm³ or more in the depth direction, measured by SIMS analysis.

3. The bonded wafer according to Claim 2, wherein the amorphous layer is located at a position at a depth of 1 µm or more from a surface of the bonded wafer on the active layer wafer side.

4. The bonded wafer according to Claim 2 or 3, wherein at least one of nitrogen and hydrogen is present at a position at a depth of 1 µm or more from a surface of the bonded wafer on the active layer wafer side.
